# EUROPEAN PATENT APPLICATION

(11) **EP 4 357 792 A1**
(43) Date of publication of application: **24.04.2024**
(21) Application number: 23160717.7
(22) Date of filing: 08.03.2023
(51) Int. Cl.: G01R 1/04, G01R 31/28

(54) **TEST BOX WITH CIRCUIT BOARDS ASSEMBLED BY MEANS OF GUIDE RAILS**

(30) Priority: 21.10.2022 CN 202222795395 U
(71) Applicant: Shenzhen Longood Intelligent Electric Co., Ltd., Shenzhen, Guangdong 523000 (CN)
(72) Inventor: LI, Jun Ming, Shenzhen, 523000 (CN); Liang, Yong, Shenzhen, 523000 (CN); Qin, You Shan, Shenzhen, 523000 (CN); Huang, Jian Lin, Shenzhen, 523000 (CN); LUO, De Feng, Shenzhen, 523000 (CN); Li, Cheng Chun, Shenzhen, 523000 (CN)
(74) Representative: Zaboliene, Reda

(57) **Abstract**

Disclosed is a test box with circuit boards assembled by means of guide rails. The test box includes a box body (1), a guide rail assembly, a main circuit board (3), functional circuit boards (4) and an adapter circuit board (5) are arranged in the box body, the functional circuit boards and the main circuit board are perpendicularly in snap fit with the guide rail assembly and are in plug-in connection to the main circuit board by means of terminals, and the adapter circuit board is installed on the inner side wall of the box body and is in plug-in connection to the functional circuit boards by means of terminals. According to the invention, the circuit boards are installed by means of the guide rails, installation procedures are simplified, assembly efficiency is improved, assembly difficulty is reduced, and a space utilization rate is improved.

## Description

### TECHNICAL FIELD

The utility model relates to a test box body, and particularly to a test box with circuit boards assembled by means of guide rails.

### BACKGROUND ART

In order to guarantee that all performances satisfy delivery requirements, most products are required to be tested before delivery. A kind of test box capable of realizing various test functions by installing corresponding circuit boards in the box body is available. In the case of such a test box in the prior art, all the circuit boards are generally fixed on an inner wall of the box body when assembled. Thus, a large inner wall space is occupied with only a small space left, which severely limits arrangement of other parts and devices and is not conducive to spatial arrangement of the box body. Further, a requirement for appearance of the box body is high, causing material waste.

In addition, since different circuit boards are usually connected to each other by means of power lines or data lines when assembled, lines are arranged in disorder, and even professionals are likely to make mistakes in welding and assembly processes, and will face numerous disordered lines in a repair process.

Since various circuit boards are connected to each other by lines, it takes plenty of time to insert the circuit boards into each other, thereby imposing higher requirements on repair and assembly personnel.

### SUMMARY

The technical problem to be solved by the utility model is to provide a test box with circuit boards assembled by means of guide rails.

In order to solve the above technical problem, the utility model employs the technical solution as follows:
a test box with circuit boards assembled by means of guide rails includes a box body, a guide rail assembly, a main circuit board, functional circuit boards and an adapter circuit board are arranged in the box body, the main circuit board is installed on an inner side wall of the box body, the functional circuit boards and the main circuit board are perpendicularly in snap fit with the guide rail assembly and are in plug-in connection to the main circuit board by means of terminals, and the adapter circuit board is installed on the inner side wall of the box body and is in plug-in connection to the functional circuit boards by means of terminals.

As a further improved solution, the guide rail assembly includes an upper guide rail board and a lower guide rail board, the upper guide rail board is installed on a top surface of the box body, the lower guide rail board is installed on a bottom surface of the box body, several guide grooves are provided on the upper guide rail board and the lower guide rail board, the functional circuit boards are installed along the guide grooves, upper side edges of the functional circuit boards are inserted into the guide grooves of the upper guide rail board, and lower side edges of the functional circuit boards are inserted into the guide grooves of the lower guide rail board.

As a further improved solution, the upper guide rail board and the lower guide rail board have the same size, and the same number of guide grooves are provided on the upper guide rail board and the lower guide rail board.

As a further improved solution, the upper guide rail board and the lower guide rail board are installed and connected to the box body by means of screws.

As a further improved solution, the box body includes a back board, side boards, a front board, a top board and a bottom board, one side board is arranged on each of two sides of the back board, the side boards are connected to the front board, the top board is installed at upper portions of the back board and the front board, the bottom board is installed on bottom surfaces of the back board and the front board, the main circuit board is installed on the back board by means of screws, and the adapter circuit board is connected to the front board.

As a further improved solution, an opening is provided on the front board, a front sliding door is movably installed on the front board, snap grooves are provided at the upper portion and a lower portion of the front board, and an upper side edge and a lower side edge of the front sliding door are movably inserted into the snap grooves of the upper portion and the lower portion of the front board respectively.

As a further improved solution, the top board divides the box body into an upper cavity and a lower cavity, the lower cavity is used for installing corresponding circuit boards, the upper cavity is used for installing electrical elements and devices, and connection ports are provided at regions of the front board and the back board corresponding to the upper cavity.

As a further improved solution, an upper cover is arranged at a top of the box body, the upper cover is installed at tops of the front board, the back board and the side boards and covers the upper cavity, and the upper cover is installed to the front board and the back board in a slide manner, or the upper cover is installed to the front board and the back board in a snap-fit manner.

As a further improved solution, inclined guide surfaces are arranged at ports of two ends of each guide groove on the upper guide rail board and the lower guide rail board.

As a further improved solution, heat dissipation holes are provided on the side boards of the box body, heat dissipation fans are arranged in the heat dissipation holes, and the heat dissipation fans are connected to the main circuit board.

Compared with the prior art, the utility model has the beneficial technical effects as follows:
1. The main circuit board is installed on the inner side wall of the box body, while the functional circuit boards are assembled in the box body instead of being fixed on an inner wall of the box body, such that not all of the circuit boards are installed on the inner side wall of the box body, the structure is more compact, and a space utilization rate may be improved. Furthermore, the box body may have a less overall size, which saves materials for preparing the box body and reduces cost advantageously.
2. By assembling the circuit boards by means of guide rails, assembly efficiency may be improved, and assembly difficulty may be reduced, which is conducive to assembly and subsequent maintenance. Gaps are provided between the plurality of functional circuit boards, and the guide rails are used for fixation, such that overall stability is maintained, and it is convenient to disassemble the circuit boards.
3. The circuit boards are in plug-in connection to each other by means of the terminals, and a traditional line connection is abandoned, which may save complicated circuit arrangement and welding, and reduce assembly difficulty between the circuit boards. Moreover, requirements provided for assembly abilities of technicians are not high, such that universality and flexibility are higher.
4. By dividing the box body into an upper layer and a lower layer, the circuit boards and other electrical elements and devices such as controllers and solenoid valves are installed layer by layer, such that arrangement is clearer.
5. By using the sliding door and the sliding upper cover, it is convenient to open the box body to repair and replace the internal circuit boards and electrical elements and devices.

### BRIEF DESCRIPTION OF THE DRAWINGS

FIG. 1 is a solid schematic structural diagram of the utility model;
FIG. 2 is an exploded schematic structural diagram of the utility model;
FIG. 3 is a schematic structural diagram of a lower guide rail board of the utility model;
FIG. 4 is a schematic structural diagram of a partial section of the utility model; and
FIG. 5 is a schematic structural diagram from another angle of view of FIG. 4.

### Reference numerals:

1-box body, 101-back board, 102-side board, 103-front board, 104-top board, 105-bottom board, 21-upper guide rail board, 22-lower guide rail board, 23-guide groove, 24-inclined guide surface, 3-main circuit board, 4-functional circuit board, 5-adapter circuit board, 6-upper cover, 7-heat dissipation fan, 8-screw, and 9-front sliding door.

### DETAILED DESCRIPTION OF THE EMBODIMENTS

Embodiments of the utility model are described in detail below, and instances of the embodiments are shown in accompanying drawings, throughout which identical or similar reference numerals denote identical or similar elements or elements having identical or similar functions. Embodiments described below with reference to accompanying drawings are illustrative and are merely used to explain the utility model, but cannot be construed as limiting the utility model.

In the description of the utility model, it should be understood that terms "central", "longitudinal", "transverse", "length", "width", "thickness", "upper", "lower", "front", "back", "left", "right", "vertical", "horizontal", "top", "bottom", "inner", "outer", "clockwise", "counterclockwise", etc. indicate orientation or positional relations based on those shown in accompanying drawings, are merely used for ease of description of the utility model and simplicity of description, and are not intended to indicate or imply that the described device or element must have a particular orientation and be constructed and operated in a particular orientation, and thus cannot be construed as limiting the utility model. In addition, terms "first" and "second" are merely used for descriptive purposes and cannot be construed as indicating or implying relative importance or implicitly specifying the number of indicated technical features. Thus, a feature defined with "first" or "second" can explicitly or implicitly include at least one of the features. In the description of the utility model, "a plurality of" means two or more, unless explicitly specified otherwise.

In the description of the utility model, it should be noted that unless explicitly specified otherwise, terms "installed", "connected to each other" and "connected to" should be understood in a broad sense, for instance, "connected" can indicate a fixed connection, a detachable connection, or an integral connection. "Connected" can indicate a mechanical connection, or an electrical connection. "Connected" can indicate a direct connection, an indirect connection by means of an intermediary medium, communication between two elements, or an interaction relation between two elements. For those of ordinary skill in the art, specific meanings of the above terms in the utility model can be understood according to specific circumstances.

### Example 1

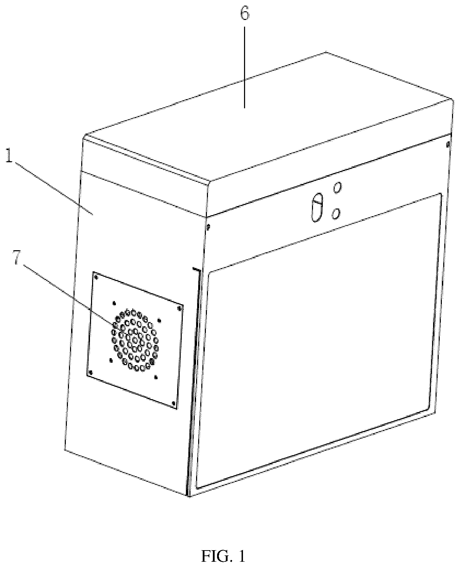

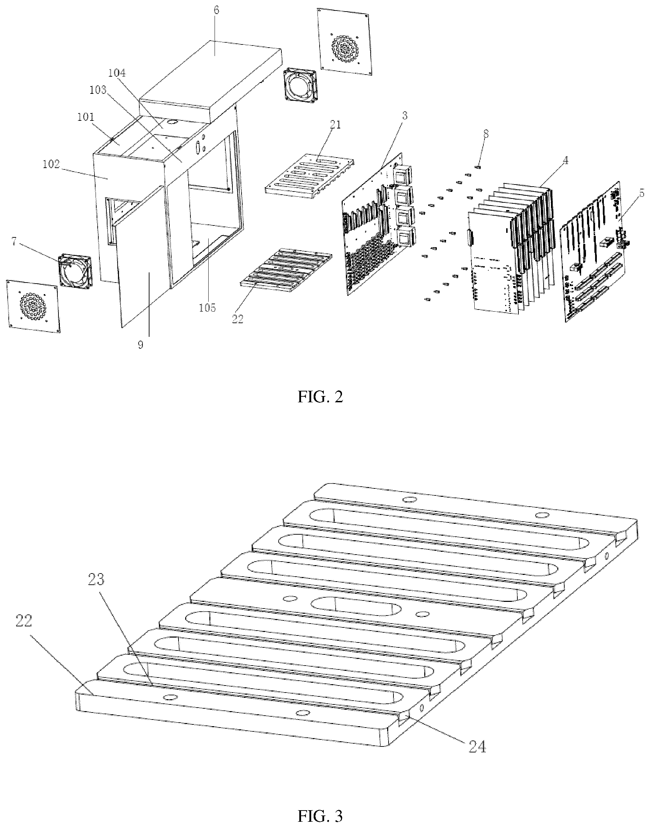

With reference to FIGs. 1-3, a test box with circuit boards assembled by means of guide rails includes a box body 1, a guide rail assembly, a main circuit board 3, functional circuit boards 4 and an adapter circuit board 5 are arranged in the box body 1, the main circuit board 3 is installed on an inner side wall of the box body 1, the functional circuit boards 4 and the main circuit board 3 are perpendicularly in snap fit with the guide rail assembly and are in plug-in connection to the main circuit board 3 by means of terminals, and the adapter circuit board 5 is installed on the inner side wall of the box body 1 and is in plug-in connection to the functional circuit boards by means of terminals. Generally, a plurality of functional circuit boards are arranged in a vertical direction, and gaps are provided between different functional circuit boards. The main circuit board, the functional circuit boards and the adapter circuit board are all known in the art, and functions or models thereof are not limited herein. Corresponding circuit boards may be flexibly selected according to objects required to be tested or test requirements, so as to guarantee that corresponding test requirements are satisfied. By installing the functional circuit boards by means of the guide rail assembly, assembly difficulty of the functional circuit boards is greatly reduced, and assembly technical requirements for operators are lowered. Moreover, through plug-in connection by means of terminals, the main circuit board is connected to the functional circuit boards, and the functional circuit boards are connected to the adapter circuit board, so as to realize communication of electrical signals. Power lines or data lines that are arranged in disorder are not required, or it is not required to weld the lines, and only plug-in connection by means of terminals is used. For example, plug-in connection ports are provided on the main circuit board, corresponding plug-in connection terminals are arranged on the functional circuit boards, and the plug-in connection terminals are directly inserted into the plug-in connection ports, such that it is not required to arrange a plurality of lines in the box body, and an interior of the box body is kept clean and tidy. Furthermore, subsequent maintenance difficulty is reduced due to reduction of lines.

The main circuit board is locked and installed on a back side wall of the box body by means of screws, which keeps a stable connection between the main circuit board and the box body, and it is guaranteed that the main circuit board is not prone to loosen in a use or carrying process. The adapter circuit board may be connected to the inner side wall of the box body by means of a support, and the main circuit board and the adapter circuit board are located on two sides of the functional circuit boards respectively to sandwich the functional circuit boards.

In addition, for the main circuit board, the functional circuit boards and the adapter circuit board, the main circuit board and the adapter circuit board are installed and fixed in a transverse direction, and the functional circuit boards are assembled in a vertical direction. In this way, the overall structure is more compact, and a space utilization rate of an interior of the box body is higher. Furthermore, such an arrangement mode between the different circuit boards is conducive to heat dissipation in an operation process.

### Example 2

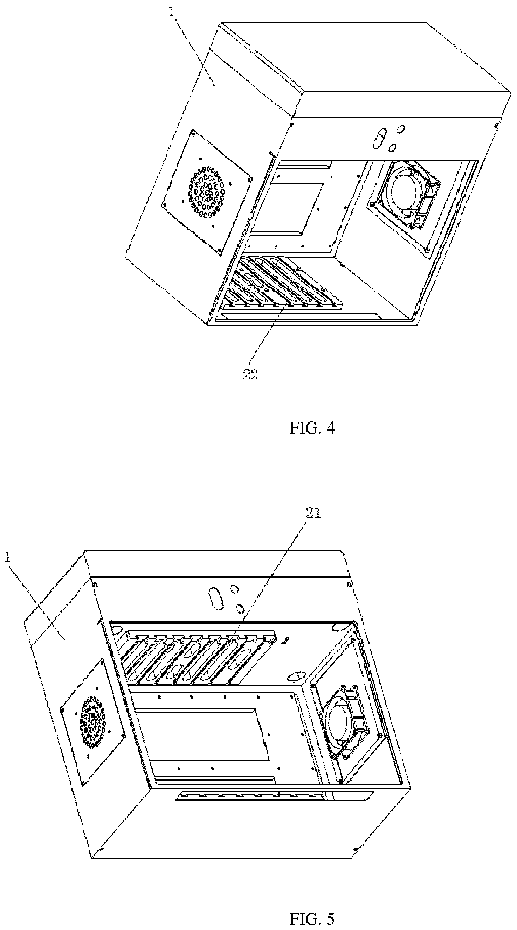

With reference to FIGs. 1-5, Example 2 makes further improvement on the basis of Example 1. The guide rail assembly includes an upper guide rail board 21 and a lower guide rail board 22, the upper guide rail board 21 is installed on a top surface of the box body 1, the lower guide rail board 22 is installed on a bottom surface of the box body 1, several guide grooves 23 are provided on the upper guide rail board 21 and the lower guide rail board 22, the functional circuit boards 4 are installed along the guide grooves 23, upper side edges of the functional circuit boards 4 are inserted into the guide grooves of the upper guide rail board 21, and lower side edges of the functional circuit boards 4 are inserted into the guide grooves of the lower guide rail board 22. The upper guide rail board and the lower guide rail board have the same size, and the same number of guide grooves are provided on the upper guide rail board and the lower guide rail board. The upper guide rail board is installed and locked to the box body by means of screws, and the lower guide rail board is installed and locked to the box body by means of screws. The upper guide rail board and the lower guide rail board generally have sizes smaller than that of an inner top surface of the box body as long as the installation number of functional circuit boards is satisfied. In an actual design process, the guide grooves on the upper guide rail board and the lower guide rail board may be one and two more than functional circuit boards to be actually assembled. In this way, it is convenient to add new functional circuit boards at any time, so as to realize more test functions, and reduce assembly difficulty, and it is not required to replace the upper guide rail board and the lower guide rail board. The upper guide rail board and the lower guide rail board are symmetrically assembled on the top surface and the bottom surface of the box body. In this way, stability of the functional circuit boards during assembly is guaranteed, and the functional circuit boards may not tilt up and down.

During specific assembly, the lower side edge of the functional circuit board is aligned with a certain guide groove on each of the upper guide rail board and the lower guide rail board, and the functional circuit board is slidably pushed into the guide grooves, and then is in plug-in connection to the main circuit board by means of a terminal arranged on the functional circuit board, such that the functional circuit board is easily and quickly assembled to the main circuit board. Generally, the guide grooves on the upper guide rail board and the lower guide rail board each has a depth of about 1 mm - 5 mm, and has a width slightly greater than a thickness of a known functional circuit boards. In this way, it is guaranteed that the functional circuit board may be slidably installed into the guide grooves. In a design process, the width may be determined according to actual situations. If the guide groove has an over large width, it is difficult to stably assemble the functional circuit board; and if the guide groove has an over small width, the functional circuit board may not be slidably installed into the guide groove. Therefore, the width will be set herein with reference to a thickness of a standard functional circuit board. After the functional circuit board is slidably installed into the guide grooves, additional fixing devices are not required for fixation, such that cumbersome procedures of installing a plurality of screws in the box body are saved. The functional circuit board directly slides into the guide grooves, the upper side edge of the functional circuit board is in snap fit with the guide groove of the upper guide rail board, and the lower side edge of the functional circuit board is in snap fit with the guide groove of the lower guide rail board, such that assembly efficiency is effectively improved.

Moreover, when the main circuit board, the upper guide rail board and the lower guide rail board are pre-assembled, it is only required to guarantee that positions of the guide grooves of the upper guide rail board and the lower guide rail board just match positions of terminal interfaces on the main circuit board. Thus, no other operations are required when the functional circuit board is reassembled, and the functional circuit board is directly pushed in the guide grooves and then is in plug-in connection to the main circuit board by applying pressure.

Further, inclined guide surfaces 24 are arranged at two ports of each guide groove 23, specifically, one inclined guide surface 24 is arranged on each of two sides of the port to form a flared inlet. In this way, it is more convenient to slide the functional circuit board into the guide grooves without taking more time to align the functional circuit board with the guide grooves. Moreover, since the guide groove generally has a small width, it is easy to slidably install the functional circuit board into the guide grooves by providing a wide flared inlet. Since the inclined guide surfaces are arranged on the two ports of each guide groove, orientation is not required to be distinguished when the upper guide rail board or the lower guide rail board is installed, such that assembly is more convenient.

### Example 3

With reference to FIGs. 1-5, further improvement is made on the basis of Example 2. The box body 1 includes a back board 101, side boards 102, a front board 103, a top board 104 and a bottom board 105, one side board 102 is arranged on each of two sides of the back board 101, the side boards 102 are connected to the front board 103, the top board 104 is installed at upper portions of the back board 101 and the front board 103, the bottom board 105 is installed on bottom surfaces of the back board 101 and the front board 103, the main circuit board 3 is installed on the back board 101 by means of screws 8, and the adapter circuit board is connected to the front board, or the adapter circuit board is connected and installed to the front board by means of an intermediate connector, such as a connection board or a connection block. The back board, the two side boards, the front board, the top board and the bottom board delimit the box body through welding, screw locking, or integral forming.

An opening is provided on the front board 103, a front sliding door 9 is movably installed on the front board 103, snap grooves are provided at the upper portion and a lower portion of the front board, and an upper side edge and a lower side edge of the front sliding door are movably inserted into the snap grooves of the upper portion and the lower portion of the front board respectively. The front sliding door may be pulled open or closed. The opening on the front board is required to be larger than the upper guide rail board and the lower guide rail board, so as to guarantee convenient installation and subsequent maintenance. When the front sliding door is closed, a closed box body is formed to protect the internal circuit boards.

The top board divides the box body into an upper cavity and a lower cavity, the lower cavity is used for installing corresponding circuit boards, the upper cavity is used for installing electrical elements and devices, connection ports are provided at regions of the front board and the back board corresponding to the upper cavity, and connection to external power supply or data lines is convenient by means of the connection ports. The top board is assembled at upper middle positions of the side boards, so as to divide the box body delimited by the back board, the side boards and the front board into an upper cavity and a lower cavity. In this way, it is not required to install all electrical elements and devices (for example, power supply and solenoid valves) and circuit boards in the same cavity, separate installation is conducive to independent inspection and maintenance, and interaction effects may not be caused. The main circuit board may be connected to electrical elements and devices installed in the upper cavity by means of the top board.

An upper cover 6 is arranged at a top of the box body 1, and the upper cover 6 is installed at tops of the front board, the back board and the side boards and covers the upper cavity. The upper cover is slidably installed to the front board and back board, such that it is convenient to open the upper cover.

In addition, heat dissipation holes are provided on the side boards of the box body 1, heat dissipation fans 7 are arranged in the heat dissipation holes, the heat dissipation fans 7 are connected to power supply installed in the upper cavity, and heat dissipation holes are provided in the back board. In this way, heat in the box body may be timely dissipated, such that each circuit board may not be damaged due to over high temperature in an operation process.

According to the utility model, during specific assembly, the lower cavity is installed first, the main circuit board is installed to the back board of the box body by means of screws, and the upper guide rail board and the lower guide rail board are installed on the top board and the bottom board of the box body. One functional circuit board is slidably installed and inserted into a certain guide groove, the upper side edge of the functional circuit board is in snap fit with the guide groove of the upper guide rail board, the lower side edge thereof is in snap fit with the guide groove of the lower guide rail board, the functional circuit board is pushed forwards to be in plug-in connection to the main circuit board, and all the functional circuit boards are sequentially installed. Then, the adapter circuit board is installed, specifically, the adapter circuit board is in plug-in connection to each functional circuit board by means of terminals, and then is fixed in the box body by means of screws. Other electrical elements and devices are installed in the upper cavity to complete connection. The front sliding door is pushed in, and the upper cover slides in for covering. Thus, overall assembly is completed. By means of the structure assembled in this way, overall concentration and stabilization of the circuit boards are guaranteed without being influenced by stress, installation difficulty is reduced, and assembly efficiency is improved.

It should be noted that what are described above are merely preferred examples of the utility model, and are not used to limit the utility model. Although the utility model has been described in detail with reference to the examples, for those skilled in the art, they can still modify technical solutions described in the foregoing examples, or make equivalent replacement for some technical features thereof. However, any modification, equivalent replacement, improvement, etc. made within the spirit and principle of the utility model, shall fall within the scope of protection of the utility model.

## Claims

1. A test box with circuit boards assembled by means of guide rails, comprising a box body, wherein a guide rail assembly, a main circuit board, functional circuit boards and an adapter circuit board are arranged in the box body, the main circuit board is installed on an inner side wall of the box body, the functional circuit boards and the main circuit board are perpendicularly in snap fit with the guide rail assembly and are in plug-in connection to the main circuit board by means of terminals, and the adapter circuit board is installed on the inner side wall of the box body and is in plug-in connection to the functional circuit boards by means of terminals.

2. The test box with circuit boards assembled by means of guide rails according to claim 1, wherein the guide rail assembly comprises an upper guide rail board and a lower guide rail board, the upper guide rail board is installed on a top surface of the box body, the lower guide rail board is installed on a bottom surface of the box body, several guide grooves are provided on the upper guide rail board and the lower guide rail board, the functional circuit boards are installed along the guide grooves, upper side edges of the functional circuit boards are inserted into the guide grooves of the upper guide rail board, and lower side edges of the functional circuit boards are inserted into the guide grooves of the lower guide rail board.

3. The test box with circuit boards assembled by means of guide rails according to claim 2, wherein the upper guide rail board and the lower guide rail board have the same size, and the same number of guide grooves are provided on the upper guide rail board and the lower guide rail board.

4. The test box with circuit boards assembled by means of guide rails according to claim 3, wherein the upper guide rail board and the lower guide rail board are installed and connected to the box body by means of screws.

5. The test box with circuit boards assembled by means of guide rails according to claim 4, wherein the box body comprises a back board, side boards, a front board, a top board and a bottom board, one side board is arranged on each of two sides of the back board, the side boards are connected to the front board, the top board is installed at upper portions of the back board and the front board, the bottom board is installed on bottom surfaces of the back board and the front board, the main circuit board is installed on the back board by means of screws, and the adapter circuit board is connected to the front board.

6. The test box with circuit boards assembled by means of guide rails according to claim 5, wherein an opening is provided on the front board, a front sliding door is movably installed on the front board, snap grooves are provided at the upper portion and a lower portion of the front board, and an upper side edge and a lower side edge of the front sliding door are movably inserted into the snap grooves of the upper portion and the lower portion of the front board respectively.

7. The test box with circuit boards assembled by means of guide rails according to claim 6, wherein the top board divides the box body into an upper cavity and a lower cavity, the lower cavity is used for installing corresponding circuit boards, the upper cavity is used for installing electrical elements and devices, and connection ports are provided at regions of the front board and the back board corresponding to the upper cavity.

8. The test box with circuit boards assembled by means of guide rails according to claim 7, wherein an upper cover is arranged at a top of the box body, the upper cover is installed at tops of the front board, the back board and the side boards and covers the upper cavity, and the upper cover is installed to the front board and the back board in a slide manner, or the upper cover is installed to the front board and the back board in a snap-fit manner.

9. The test box with circuit boards assembled by means of guide rails according to claim 8, wherein inclined guide surfaces are arranged at ports of two ends of each guide groove on the upper guide rail board and the lower guide rail board.

10. The test box with circuit boards assembled by means of guide rails according to claim 9, wherein heat dissipation holes are provided on the side boards of the box body, and heat dissipation fans are arranged in the heat dissipation holes.
